# FASCICULE DE BREVET EUROPEEN

(11) **EP 3 234 652 B1**
(45) Date de publication et mention de la délivrance du brevet: **06.01.2021**
(21) Numéro de dépôt: 15817836.8
(22) Date de dépôt: 21.12.2015
(51) Int. Cl.: G01T 3/08

(54) **PROCÉDÉ DE RÉALISATION D'UN DÉTECTEUR DE NEUTRONS ET DÉTECTEUR DE NEUTRONS**
VERFAHREN ZUR HERSTELLUNG EINES NEUTRONENDETEKTORS UND NEUTRONENDETEKTOR
METHOD FOR PRODUCING A NEUTRON DETECTOR AND NEUTRON DETECTOR

(30) Priorité: 19.12.2014 FR 1463019
(43) Date de publication de la demande: 25.10.2017
(73) Titulaire: Commissariat à l'Énergie Atomique et aux Énergies Alternatives, 75015 Paris (FR); Universite d'Aix Marseille, 13284 Marseille Cedex 07 (FR)
(72) Inventeur: OTTAVIANI, Laurent, 13012 Marseille (FR); VERVISCH, Vanessa, 13012 Marseille (FR); ISSA, Fatima, 13013 Marseille (FR); LYOUSSI, Abdallah, 04100 Manosque (FR)
(74) Mandataire: Hautier, Nicolas
(86) Numéro de dépôt international: PCT/EP2015/080855
(87) Numéro de publication internationale: WO 2016/097415

(56) Documents cités:
- VERVISCH V ET AL: "Nuclear radiation detector based on ion implanted p-n junction in 4H-SiC", 2013 3RD INTERNATIONAL CONFERENCE ON ADVANCEMENTS IN NUCLEAR INSTRUMENTATION, MEASUREMENT METHODS AND THEIR APPLICATIONS (ANIMMA), IEEE, 23 juin 2013 (2013-06-23), pages 1-5, XP032560659, DOI: 10.1109/ANIMMA.2013.6728002
- LAURENT OTTAVIANI ET AL: "Study of Defects Generated by Standard- and Plasma-Implantation of Nitrogen Atoms in 4H-SiC Epitaxial Layers", MATERIALS SCIENCE FORUM, vol. 725, 1 janvier 2012 (2012-01-01), pages 41-44, XP055222415, DOI: 10.4028/www.scientific.net/MSF.725.41
- LAURENT OTTAVIANI ET AL: "Influence of Heating and Cooling Rates of Post-Implantation Annealing Process on Al-Implanted 4H-SiC Epitaxial Samples", MATERIALS SCIENCE FORUM, vol. 645-648, 1 avril 2010 (2010-04-01), pages 717-720, XP055222404, DOI: 10.4028/www.scientific.net/MSF.645-648.717
- ISSA F ET AL: "Radiation Silicon Carbide Detectors Based on Ion Implantation of Boron", IEEE TRANSACTIONS ON NUCLEAR SCIENCE, IEEE SERVICE CENTER, NEW YORK, NY, US, vol. 61, no. 4, 1 août 2014 (2014-08-01), pages 2105-2111, XP011556467, ISSN: 0018-9499, DOI: 10.1109/TNS.2014.2320943 [extrait le 2014-08-14]

## Description

### DOMAINE DE L'INVENTION

La présente invention est relative au domaine de la détection de particules présentes dans un environnement particulier. Les particules atomiques et/ou subatomiques (nucléaires) sont généralement détectées par la signature qu'elles produisent par interaction avec leur environnement. La présente invention concerne notamment un procédé et un dispositif pour la détection de neutrons. Elle trouvera pour application avantageuse mais non limitative la détection de neutrons et/ou de photons en environnement sévère.

### ARRIERE-PLAN TECHNOLOGIQUE

Le principe de fonctionnement des détecteurs de neutrons repose sur l'interaction de neutrons, par exemple thermiques (énergie de 0.025eV i.e. en équilibre thermique dans un milieu à 20 °C), avec des atomes et/ou noyaux d'un matériau convertisseur de neutrons. Par exemple l'interaction de neutrons avec du Bore isotope 10 (¹⁰B) produit des particules (noyaux) alpha (⁴He) et lithium (⁷Li). Selon un exemple de configuration les particules sont générées dans des directions opposées selon les réactions suivantes (et leurs probabilités associées) avec une énergie Q :

¹⁰B + neutron → ⁷Li + ⁴He (Q = 2.72 MeV) 6 %

¹⁰B + neutron → ⁷Li + ⁴He (Q = 2.31 MeV) 94 %

Le détecteur requiert ainsi la présence d'une Couche de Conversion de Neutrons (CCN) pour convertir *in fine* les neutrons incidents en paires électrons-trous. L'ionisation du matériau, produite par la génération des particules/noyaux ⁷Li et ⁴He, peut être ensuite détectée grâce au champ électrique présent aux bornes d'une Zone de Charge d'Espace (ZCE). La zone de charge d'espace (ZCE), aussi appelée zone de déplétion, ou zone désertée, correspond à la région qui apparait dans une jonction p-n, entre une zone dopée n et une zone dopée p. Elle est appelée « zone de déplétion » ou « zone désertée » parce qu'elle est dépourvue de porteurs libres, et elle est appelée « zone de charge d'espace » parce qu'elle est constituée de deux zones chargées électriquement (contrairement au reste du semi-conducteur n et du semi-conducteur p qui sont globalement neutres). Ainsi, un détecteur requiert la présence d'une jonction p-n pour générer ladite zone de charge d'espace et ainsi collecter les porteurs issus des réactions susmentionnées.

Le document « Nuclear Radiation Detector Based on Ion Implanted p-n Junction in 4H-SiC », 2013 3rd International Conférence on Advancements in Nuclear Instrumentation, Measurement Methods and Their Applications, ANIMMA 2013, IEEE , 2013, p. 672800, concerne un détecteur de neutrons thermiques. Ce détecteur, comprend une couche épaisse de type n+ formé par du SiC, une couche dopée p+ par implantation d'ions aluminium (Al+) dans la couche n+ de SiC. La couche dopée p+ définit avec la couche dopée n+ la zone de charge d'espace (ZCE) qui s'étend dans la couche n+ à partir de l'interface n/p. Par ailleurs, le détecteur comprend une couche riche en bore isotope 10 (10B) formant la couche de conversion de neutrons (CCN). En outre, ce détecteur de neutron nécessite une polarisation. Ce document enseigne qu'une augmentation de la polarisation permet d'améliorer la qualité du signal.

Le document « Thermal neutron détection enhancement by 10B implantation in silicon carbide sensor », MRS Online Proceeding Library Archive 1693 . January 2014 DOI 10.1557/opl.2014691 décrit un détecteur du même type. Ce document décrit plusieurs détecteurs comprenant chacun une couche épaisse de type n+ formé par du 4H-SiC, une couche dopée p+ par implantation d'ions aluminium (Al+) dans la couche n+ de 4H-SiC. L'interface entre ces deux couches forme une zone de charge d'espace (SCR). Par ailleurs, dans chacun des détecteurs décrits, on forme par implantation de bore est à distance de la SCR, une couche de conversion de neutrons (NCL).

Le document FR2572540 concerne la détection de neutrons thermiques par une diode à semi-conducteur. Ce document nécessite la mise en place d'une polarisation inverse qui complexifie détecteur et réduit la discrimination entre les neutrons et les particules gamma.

Les détecteurs décrits dans ces documents sont globalement satisfaisants. En revanche, il s'est avéré qu'ils délivrent des résultats instables dans le temps.

La présente invention vise à proposer une solution pour résoudre cet inconvénient.

### RESUME DE L'INVENTION

A cet effet, la présente invention propose un procédé de réalisation d'un dispositif de détection d'un flux de neutrons présentant des caractéristiques comprises dans des gammes prédéterminées. Le procédé comprend avantageusement au moins une phase de détermination de paramètres comprenant les étapes suivantes :
- simuler la pénétration d'un flux de neutrons incidents présentant des caractéristiques comprises dans lesdites gammes prédéterminées à travers un empilement modélisé comprenant successivement et dans l'ordre au moins: une première électrode ; un substrat comprenant : une première couche dopée comprenant au moins une première espèce dopante de manière à ce que la première couche soit une couche dopée n ou une couche dopée p, la première couche étant formée par le substrat ; une deuxième couche dopée comprenant au moins une deuxième espèce dopante de manière à ce que la deuxième couche soit l'autre parmi une couche dopée n ou une couche dopée p de sorte à former, à une interface entre les première et deuxième couches, une jonction p-n et de manière à former dans la première couche (et à partir de l'interface entre les première et deuxième couches), une zone de charge d'espace ; la deuxième couche étant formée par implantation de la deuxième espèce dopante dans le substrat ; la deuxième espèce dopante étant prise parmi les matériaux convertisseurs de neutrons, la deuxième couche formant ainsi une couche de conversion de neutrons ; une deuxième électrode ;
- simuler au moins un pic de défauts crées dans la première couche par les lacunes et/ou l'ionisation des particules générées par les collisions entre les atomes de la deuxième espèce dopante et les neutrons dudit flux de neutrons incidents présentant des caractéristiques comprises dans lesdites gammes prédéterminées;
- identifier la profondeur du pic de défauts le plus proche de l'interface entre les première et deuxième couches de l'empilement modélisé;
- déterminer des paramètres des première et deuxième couches que devrait présenter l'empilement modélisé, notamment la profondeur de ladite implantation de la deuxième espèce dopante dans le substrat pour former la deuxième couche (et donc l'épaisseur de la deuxième couche) et les teneurs (ou concentration) en première et deuxième espèces dopantes des première et deuxième couches, de manière à ce que la zone de charge d'espace s'étende depuis ladite interface entre les première et deuxième couches et dans la première couche sur une profondeur inférieure à ladite profondeur identifiée dudit pic de défauts de manière à ce que la zone de charge d'espace ne comprenne pas de pic de défauts.

Ainsi, l'interface entre la première couche et la deuxième couche dopée avec la deuxième espèce dopante définit dans la première couche et à partir de l'interface entre les première et deuxième couches, une zone de charge d'espace. Par ailleurs, cette même deuxième espèce dopante est prise parmi les matériaux convertisseurs de neutrons, la deuxième couche formant ainsi une couche de conversion de neutrons. Ainsi, la deuxième couche formant la couche de conversion de neutrons s'étend jusqu'à la zone de charge d'espace. La zone de charge d'espace et la couche de conversion de neutrons sont donc adjacentes. Cela a pour conséquence que le maximum du taux d'ionisation, en sortie de CCN, est dans la ZCE. Or le signal détecté dépend étroitement du taux d'ionisation détecté. Par conséquent, cette structure du détecteur permet d'améliorer considérablement le signal. A l'inverse, s'il existe une couche intermédiaire entre CCN et ZCE, les produits de la réaction entre les neutrons et l'espèce dopante sont en partie absorbés par cette couche intermédiaire.

Par ailleurs, le procédé comprend avantageusement une étape de fabrication du dispositif de détection dans laquelle on réalise la première couche puis on réalise la deuxième couche par implantation de la deuxième espèce dopante dans une partie de la première couche, ladite implantation, en particulier la profondeur d'implantation et la teneur en deuxième espèce dopante étant réalisée en fonction desdits paramètres déterminés de manière à ce que dans le dispositif fabriqué la zone de charge d'espace s'étende depuis ladite interface entre les première et deuxième couches et dans la première couche sur une profondeur inférieure à ladite profondeur identifiée dudit pic de défauts.

Ainsi, le procédé selon l'invention prévoit, au cours d'une première phase, de simuler la profondeur des pics de défauts et de réaliser la deuxième couche du substrat de manière à former la zone de charge d'espace pour qu'elle ne contienne pas de pic de défauts. Le pic de défauts est avantageusement prévu par simulation. De préférence il s'agit d'une simulation numérique mise en oeuvre par un ordinateur. Le pic de défauts peut également être simulé de la manière non informatique, en étant identifié, après sa création, par des analyses de type microscopie électronique effectuées sur au moins un empilement modélisé préalablement fabriqué et soumis à un flux de neutrons présentant des caractéristiques comprises dans lesdites gammes prédéterminées.

La synergie entre le rapprochement de la ZCE et de la CCN d'une part et la configuration de la ZCE qui comprend le pic de défauts d'autre part, permet de détecter aux bornes de la zone de charge d'espace un signal important et précis, et ceci sans nécessiter de polarisation. En effet, avec le détecteur selon l'invention un signal suffisant est détecté à 0 Volts aux bornes de la ZCE. Avec un dispositif de l'art antérieur, aucun signal ne serait détecté à appliquant une tension nulle aux bornes de la ZCE ou bien le signal existant aurait un rapport signal sur bruit beaucoup trop faible. Avec les détecteurs de l'art antérieur, une polarisation est donc indispensable.

Or, dans le cadre du développement de la présente invention il s'est avéré qu'avec le détecteur mentionné dans l'état la qualité du signal fourni se dégrade dans le temps. Cette limitation en termes de stabilité est particulièrement difficile à anticiper.

Dans le cadre du développement de la présente invention il a été remarqué que cette absence de stabilité provient d'une dégradation dans le temps de la ZCE. Il a également été identifié que cette dégradation provient de l'application d'une polarisation aux bornes de la ZCE.

En effet, il est très probable que la polarisation ionise les lacunes dans la ZCE et perturbe le matériau de la ZCE ce qui le modifie dans le temps. Ainsi le champ électrique de la ZCE qui est généré par les produits de la réaction entre neutrons et matériau convertisseur de neutrons, varie au cours du temps. La conséquence directe de cet endommagement de la ZCE est la présence d'un signal sortant dégradé et instable dans le temps. Cela est particulièrement préjudiciable pour des prises de mesure continues ou ponctuelles qui s'étalent dans le temps et où il faut surveiller l'évolution du signal.

Par ailleurs, plus on augmente la polarisation inverse, ce que préconise l'art antérieur pour augmenter le ratio signal/bruit, plus on endommage la ZCE et donc on réduit d'autant la stabilité des résultats fournis et donc la durée de vie du détecteur.

Puisqu'il ne nécessite pas de polarisation, le détecteur ainsi réalisé est plus simple et moins couteux que ceux de l'état de la technique qui nécessitent une polarisation.

Par ailleurs, l'absence de polarisation rend le détecteur selon l'invention plus robuste et fiable dans des conditions d'utilisation sévères notamment du fait de l'absence des connexions, câbles et composants nécessaires à la polarisation.

Avantageusement, la deuxième couche du substrat est formée de manière à ce que la zone de charge d'espace contienne le maximum du taux d'ionisation. Le taux d'ionisation est avantageusement déterminé par simulation. De préférence il s'agit d'une simulation numérique mise en oeuvre par un ordinateur. Le taux d'ionisation peut également être simulé de la manière non informatique, en étant identifié, après sa création, par des analyses physico-chimique de type Spectroscopie de Masse à Ionisation Secondaire (acronyme « SIMS »), en assimilant le profil des ions au profil d'ionisation du matériau. Il est par ailleurs possible d'évaluer le taux d'ionisation du matériau en mesurant la réponse du détecteur en fonction de la tension de polarisation.

D'autre part, la précision du signal détecté par le détecteur permet une discrimination entre neutrons et gamma.

L'invention permet ainsi d'accroitre significativement la fiabilité et la durée de vie des détecteurs, notamment en environnement sévère.

Selon un mode de réalisation particulier, le substrat est en carbure de silicium (SiC). Cela permet d'accroitre très significativement la robustesse, la fiabilité et la durée de vie du détecteur dans des conditions d'utilisation sévères.

Selon un autre mode de réalisation, l'invention concerne un détecteur d'un flux de neutrons présentant des caractéristiques comprises dans des gammes prédéterminées, le détecteur comprenant au moins un empilement de couches comprenant successivement et dans l'ordre : une première électrode; un substrat comprenant : une première couche dopée n ou respectivement p comprenant au moins une première espèce dopante n ou respectivement p, la première couche étant formée par le substrat ; une deuxième couche dopée p ou respectivement n comprenant au moins une deuxième espèce dopante de sorte à former, à une interface entre les première et deuxième couches, une jonction p-n et de manière à former dans la première couche et à partir de l'interface entre les première et deuxième couches, une zone de charge d'espace; une deuxième électrode. Avantageusement, la deuxième couche est formée par implantation de la deuxième espèce dopante dans le substrat ; la deuxième espèce dopante étant prise parmi les matériaux convertisseurs de neutrons pour former une couche de conversion de neutrons. Avantageusement, les paramètres des première et deuxième couches, en particulier la profondeur d'implantation de la deuxième espèce dopante dans le substrat pour former la deuxième couche (et donc l'épaisseur de la deuxième couche) et les teneurs en première et deuxième espèces dopantes respectivement des première et deuxième couches, sont choisis pour que la zone de charge d'espace s'étend depuis ladite interface entre les premières et deuxième couches et dans la première couche sur une profondeur inférieure à une profondeur où se situerait un pic de défauts qui serait créé dans la première couche par des lacunes et/ou une ionisation de particules générées par les collisions entre des atomes de la deuxième espèce dopante et des neutrons si le détecteur était exposé à un flux de neutrons dont les paramètres sont compris dans lesdites gammes prédéterminées.

L'invention concerne d'autre part une utilisation du détecteur dans lequel on expose le détecteur à un flux de neutrons dont les paramètres sont compris dans lesdites gammes prédéterminées.

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
La FIGURE 1 illustre une vue en coupe du détecteur de neutrons selon la présente invention.
La FIGURE 2 illustre des profils d'ionisation liés aux particules/noyaux de lithium ⁷Li et d'hélium ⁴He ainsi que les profils de défauts ou lacunes issus de l'interaction de ces particules.
Les FIGURES 3A à 3H illustrent des vues schématiques représentant les différentes étapes de réalisation du détecteur selon la présente invention.
La FIGURE 4 est un graphe illustrant la superposition de profils de Bore dans la couche épitaxiée de carbure de silicium.
La FIGURE 5 est un graphe illustrant la variation du signal en fonction de la tension de polarisation.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et films ne sont pas représentatives de la réalité.

### DESCRIPTION DETAILLEE

Il est précisé que dans le cadre de la présente invention, le terme « sur » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

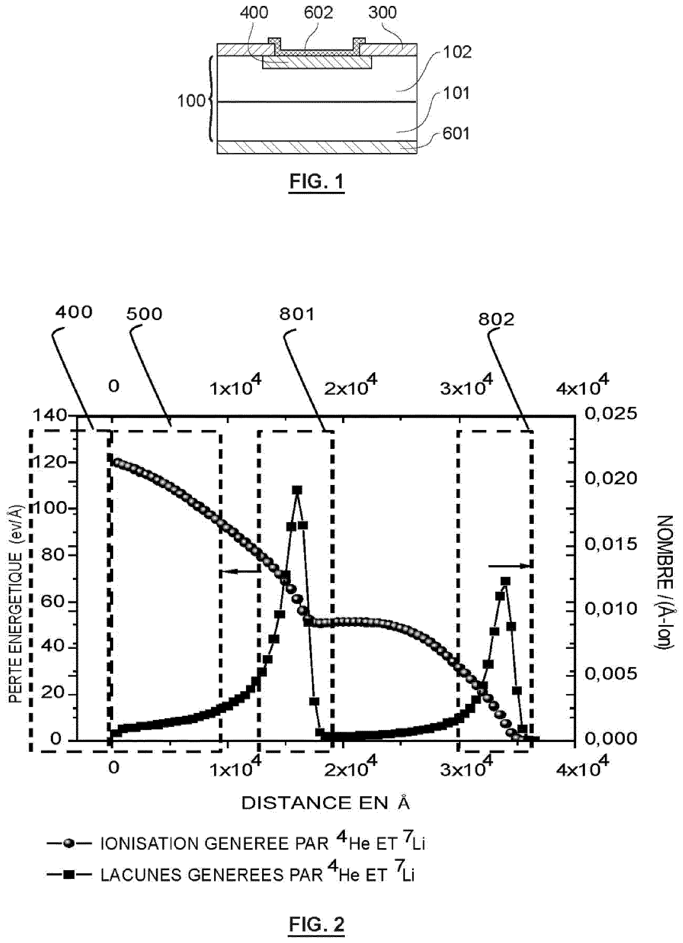

Il est précisé que dans le cadre de la présente invention, l'épaisseur d'une couche se mesure selon une direction perpendiculaire à la surface selon laquelle cette couche présente son extension maximale. Typiquement, lorsque les couches forment des portions de cylindre, leur épaisseur est prise selon une direction perpendiculaire aux deux faces formant des disques. Sur la figure 1, l'épaisseur est prise selon la verticale.

Il en est de même pour mesurer une profondeur, par exemple d'une zone de charge d'espace ou d'une implantation.

Dans le cadre de la présente invention la profondeur de la zone de charge d'espace ou des pics de défaut se mesure depuis l'interface entre les première et deuxième couches.

L'invention s'applique à la détection de neutrons thermiques, lents, épithermiques et rapides. On qualifie de neutrons lents, les neutrons possédant une énergie variant de 0,025 eV à 10 eV. On qualifie de neutrons épithermiques les neutrons d'énergie comprise entre 10 eV et 500 keV. On qualifie de neutrons rapides, les neutrons possédant une énergie supérieure à 0,5 MeV. En somme, l'invention s'applique à la détection de neutrons dont l'énergie varie de 0,025 eV à quelques méga-électron-volts voire quelques dizaines de méga-électron-volts.

Avant d'entamer une revue détaillée de modes de réalisation de l'invention, sont énoncées ci-après des caractéristiques optionnelles qui peuvent éventuellement être utilisées en association ou alternativement avec le procédé selon l'invention ou avec le détecteur:
- Le substrat comprend du carbure de silicium (SiC). Cela contribue à la fiabilité du détecteur en environnement sévère.
- On réalise la deuxième couche par implantation de la deuxième espèce dopante dans une partie de la première couche en fonction desdits paramètres déterminés.
- L'étape de détermination des paramètres du détecteur est au moins en partie assistée ou mise en oeuvre par ordinateur. Il s'agit typiquement d'une simulation numérique mise en oeuvre par un ordinateur comprenant au moins un microprocesseur. En particulier, l'étape de simulation de la pénétration d'un flux de neutrons incidents est mise en oeuvre par ordinateur.
- Alternativement, l'étape de détermination des paramètres du détecteur peut également être simulée de la manière non informatique, par des analyses de type microscopie électronique sur des détecteurs préalablement fabriqués. En particulier, l'étape d'identification du pic de défauts comprend des analyses de microscopie électronique effectuées sur au moins un empilement modélisé préalablement fabriqué et soumis à un flux de neutrons présentant des caractéristiques comprises dans lesdites gammes prédéterminées.
- L'étape d'identification de l'empilement de couches comprend par exemple la simulation ou la modélisation de l'empilement. Alternativement, elle peut comprendre la réalisation matérielle d'un empilement.
- lesdites caractéristiques prédéterminées du flux de neutrons comprennent au moins l'un parmi: une énergie donnée et/ou un flux et/ou une fluence et/ou une intensité
- Au cours de l'étape de fabrication on détermine la position de la zone de charge d'espace, en particulier la profondeur de l'interface p/n (profondeur de l'interface entre les première et deuxième couches) en fonction des paramètres suivants : l'épaisseur de la deuxième couche (en µm) et/ou l'énergie de l'implantation de la deuxième espèce dopante (en eV).
- Au cours de l'étape de fabrication on règle la profondeur de la zone de charge d'espace en fonction des paramètres suivants: la teneur en espèce dopante de la première couche (en at/cm³), la dose de l'implantation de la deuxième espèce dopante (en at/cm²), la profondeur de l'implantation de la deuxième espèce dopante.
- Selon un mode de réalisation privilégié, au cours de l'étape de fabrication on détermine la position de la zone de charge d'espace, en particulier la profondeur de l'interface p/n (profondeur de l'interface entre les première et deuxième couches) en fonction de l'énergie de l'implantation de la deuxième espèce dopante (en eV). Au cours de l'étape de fabrication on règle l'épaisseur de la zone de charge d'espace en fonction de la concentration en première dopante de la première couche (en at/cm³) et de la dose de l'implantation de la deuxième espèce dopante (en at/cm²).
- La première couche du substrat est exempte de la deuxième espèce dopante.
- La deuxième espèce dopante comprend du bore isotope 10 (¹⁰B). Selon un mode de réalisation, la deuxième espèce dopante est uniquement du bore, ce bore comprenant du bore isotope 10 (¹⁰B). De préférence la deuxième espèce dopante est uniquement du bore isotope 10 (¹⁰B).
- La première couche du substrat comprend au moins une couche inférieure dopée n+ et une couche supérieure dopée n ; ladite couche supérieure comprenant une concentration en première espèce dopante comprise entre 10¹⁴ et 10¹⁶ at/cm³.
- La profondeur de la zone de charge d'espace dépend des paramètres de dopage et d'épaisseur de la couche supérieure de la première couche du substrat.
- La première électrode est au contact de la première couche, la première couche est au contact de la deuxième couche et la deuxième électrode est au contact de la deuxième couche. De préférence, la première électrode est au contact de la première couche. De préférence, la première couche est au contact de la deuxième couche. De préférence, la deuxième électrode est au contact de la deuxième couche.
- Le pic de défauts est une zone dans laquelle la concentration en défauts est supérieure ou égale à 0.005 lacune/(Å-ion). Les défauts sont générés par une collision entre des neutrons et ladite deuxième espèce dopante.
- La zone de charge d'espace s'étend sur une distance comprise entre 0 et quelques dizaines de microns.
- Le détecteur comprend une unique deuxième espèce dopante. Ainsi avec une seule espèce, typiquement du ¹⁰B, on forme la CCN et on définit, avec le substrat, la jonction p/n.
- La zone de charge d'espace est adjacente à la couche de conversion de neutrons, c'est-à-dire à son contact direct ou à son voisinage immédiat. Il n'y a pas de couche intermédiaire entre ZCE et CCN. La zone de charge d'espace est adjacente ou au contact direct d'une partie au moins de la ZCE.
- La CCN s'étend depuis l'électrode au contact de la ZCE. Cette caractéristique permet ainsi une augmentation importante de la qualité du signal.
- La CCN est distincte des deux électrodes. La CCN est située entre les deux électrodes. Selon un mode de réalisation non limitatif, la CCN est en partie au moins au contact de l'une des électrodes.
- Le détecteur ne comprend pas de polarisation de la ZCE. Il est exempt de dispositif de polarisation.
- On règle la profondeur de la zone de charge d'espace, notamment en ajustant les teneurs en première et deuxième espèces dopantes des première et deuxième couches et notamment en ajustant l'implantation de la deuxième espèce dopante de manière à ce que la zone de charge d'espace s'étende dans la première couche, à partir de ladite interface, sur une profondeur suffisante pour comprendre la zone où le taux d'ionisation des particules générées par lesdites collisions entre les atomes de la deuxième espèce dopante et les neutrons dudit flux de neutrons incidents présentant des caractéristiques comprises dans lesdites gammes prédéterminées est le plus élevé. Ainsi, au regard de toute la profondeur du substrat, le taux d'ionisation présente son maximum dans cette zone.
- La première électrode et la deuxième électrode comprennent un matériau métallique.
- Selon un mode de réalisation, l'implantation de la deuxième espèce dopante est réalisée au moyen de Bore isotope 10, avec une énergie comprise entre 20 et 180 keV et une dose comprise entre 10¹⁵ et 10¹⁷ cm⁻².
- Selon un autre mode de réalisation, l'implantation de la deuxième espèce dopante est réalisée par implantation plasma de Bore isotope 10, avec une tension comprise entre 5 et 15 kV et une dose comprise entre 10¹⁵ et 10¹⁷ cm⁻².
- Selon un autre mode de réalisation, la concentration de deuxième espèce dopante, par exemple du bore isotope 10, dans le substrat est supérieure à 1x10¹⁹ at/cm³. De préférence, elle est comprise entre 1x10¹⁹ at/cm³ et à 1x10²¹ at/cm³.
- Avantageusement, après implantation de la deuxième espèce dopante, on réalise ensuite un recuit d'activation de la deuxième espèce implantée. Ce recuit permet d'activer électriquement les atomes de la deuxième espèce dopante. Par exemple si les atomes de la deuxième espèce dopante sont des atomes de Bore, ce recuit permet la création de la couche p+. Par ailleurs, ce recuit permet de supprimer une partie au moins des défauts crées par l'implantation de bore.
- Selon un mode de réalisation non limitatif, le recuit est effectué sous argon. Selon un mode de réalisation non limitatif, le recuit est effectué à des températures comprises entre 900 et 1700°C, pour une durée comprise entre 30 et 120 minutes.
- La réalisation de la couche supérieure dopée n comprend de préférence un dépôt chimique en phase vapeur.
- La réalisation de la première électrode et la réalisation de la deuxième électrode comprennent une métallisation.
- Utilisation du détecteur pour l'une quelconque des applications suivantes : caractérisation de colis de déchets radioactifs, le suivi et le contrôle des opérations de démantèlement d'installations nucléaires, le contrôle nucléaire dans des usines de retraitement de combustible nucléaire, le pilotage de réacteurs nucléaires expérimentaux et de puissance, le contrôle de l'environnement.
- Utilisation du détecteur pour la géo prospection minière ou pétrolière.
- Utilisation du détecteur pour la physique médicale.
- Utilisation du détecteur pour le domaine de la sécurité intérieure.

La **figure 1** illustre le dispositif de détection de neutrons selon la présente invention. Afin de simuler la pénétration d'un flux de neutrons incidents dont les paramètres sont compris dans des gammes prédéterminées à travers le dispositif, il est nécessaire au préalable de déterminer un empilement modélisé de couches correspondant au dispositif de détection. L'empilement modélisé comprend notamment un substrat. Selon l'invention le substrat comprend une première couche 100 dopée comprenant au moins une première espèce dopante de manière à ce que la première couche 100 soit une couche dopée n ou une couche dopée p. La première couche 100 comprend de préférence un empilement de couches dont une couche inférieure 101 et une couche supérieure 102. Avantageusement, la couche inférieure 101 comprend de préférence du carbure de silicium (SiC). La couche inférieure 101 est avantageusement fortement dopée (niveau de dopage de l'ordre de quelques 10¹⁸ cm³). La couche supérieure 102 du substrat 100 comprend, quant à elle, préférentiellement du carbure de silicium, par exemple de type n, à faible niveau de dopage (concentration comprise entre 1x10¹⁴ et 1x10¹⁶ at/cm³).
Dans une réalisation alternative de l'invention, la couche inférieure 101 est moins dopée que la couche supérieure 102. Ainsi, dans cette réalisation alternative, la couche 102 est fortement dopée, alors que la couche 101 est faiblement dopée.

Le substrat comprend avantageusement une deuxième couche 400 dopée comprenant au moins une deuxième espèce dopante de manière à ce que la deuxième couche 400 soit l'autre parmi une couche dopée n ou une couche dopée p.

Le substrat comprend une deuxième couche 400 dopée de type p, selon un mode particulier de réalisation. La deuxième couche 400 est de préférence réalisée par implantation d'ions de type p dans la couche supérieure 102 de la première couche 100.

Avantageusement, l'espèce dopante de la deuxième couche 400 est un matériau convertisseur de neutrons. Ainsi la deuxième couche 400 forme avantageusement une couche de conversion de neutrons comme cela sera décrit en détail par la suite.

Avantageusement, une couche additionnelle 300 fait office de masque lors de l'implantation.

Suite à l'implantation de la première couche 100 initialement dopée de type n par un matériau dopant de type p formant la deuxième couche 400, le semi-conducteur de type n de la première couche 100 est mis en contact avec un semi-conducteur de type p (jonction p-n) de la deuxième couche 400, les électrons majoritaires du côté n (respectivement les trous majoritaires du côté p) vont être entrainés vers la zone p (respectivement vers la zone n pour les trous) où ils sont minoritaires, par phénomène de diffusion. Ce faisant, ils laissent derrière eux des ions de charges opposées, qui assuraient la neutralité électrique des semi-conducteurs n et p avant qu'ils ne soient mis en contact. Enfin, les électrons (respectivement les trous) qui se sont déplacés vers la zone p se recombinent avec les trous majoritaires (respectivement avec les électrons majoritaires en zone n). Il y a donc apparition dans le semi-conducteur de type n c'est-à-dire dans la couche supérieure 102 de la première couche 100, d'une zone dépourvue d'électrons appelée zone de charge d'espace 500 à la jonction (respectivement une zone dépourvue de trous dans le semi-conducteur de type p), alors que cette zone 500 contient toujours les ions résultant des atomes dopants.

La deuxième couche 400 formant la couche de conversion de neutrons, cette dernière est au voisinage immédiat, et plus précisément adjacente à la zone de charge d'espace 500, ce qui procure de nombreux avantages comme cela sera décrit en détail par la suite.

Le dispositif de détection comprend également une première électrode 601 et une deuxième électrode 602, représentant respectivement l'anode et la cathode.

Préférentiellement, la première couche 100 du substrat est directement au contact de la première électrode 601 et la deuxième couche 400 est directement au contact de la deuxième électrode 602.
L'empilement comprenant la première couche 100, la deuxième couche 400, la première électrode 601 et la deuxième électrode 602 forme l'empilement modélisé, empilement à partir duquel est simulée la pénétration du flux de neutrons incidents. C'est cet empilement modélisé qui permet de déterminer les paramètres qui serviront à fabriquer l'empilement réel du dispositif de détection.

La **figure 2** illustre des profils d'ionisation liés aux particules de Lithium (⁷Li) et d'Hélium (⁴He) générées par les réactions entre les neutrons incidents et les atomes du matériau dopant (soit la deuxième espèce dopante), par exemple le Bore (¹⁰B). Ces profils sont obtenus par simulation à partir de l'empilement modélisé. A l'aide de la simulation, lors d'une phase de détermination des paramètres, on modifie les paramètres des différentes couches formant l'empilement modélisé de sorte à déterminer les paramètres d'un empilement réel. On entend par « ionisation », le fait qu'une particule, par exemple une particule alpha d'Hélium (⁴He), dotée d'une grande énergie, puisse expulser un électron d'un atome rencontré sur son chemin, c'est-à-dire appartenant au milieu traversé, soit la première couche 100. L'atome qui a perdu un électron devient un ion. La particule ionise une pluralité d'atomes présents dans la première couche 100 avant de s'arrêter. La perte en énergie due à l'ionisation est proportionnelle à la masse et au carré de la charge de la particule. Elle varie avec sa vitesse. Quand la particule est lente, elle passe davantage de temps proche d'un atome et elle a plus de chances de provoquer une collision. En revanche, l'ionisation spécifique suite au transfert linéique d'énergie de la particule ionisante croit en fonction du parcours de la particule. Il est maximal à la fin de son parcours. Autrement dit la particule ionisante dépose une faible partie de son énergie au début de son parcours. La plus grande partie est déposée à la fin du parcours, i.e. quand la particule s'apprête à s'arrêter (pic de Bragg).

À force d'arracher des électrons, la particule perd son énergie, se ralentit et finit par s'arrêter. Plus l'ionisation est intense, plus le trajet est court. Tel est le cas des particules alpha, dont la longueur du parcours, dépend de l'énergie initiale. Les électrons et les ions créés se recombinent après le passage de la particule ionisante.
Ces réactions ont avantageusement lieu près de la limite inférieure de la couche de conversion de neutrons 400.

La figure 2 illustre également les profils de défauts (lacunes) issus desdites particules en fin de parcours. Pour obtenir ces profils, une étape de simulation est réalisée de sorte à simuler la pénétration à travers la deuxième couche 400 d'un flux de neutrons incidents dont les paramètres sont compris dans des gammes prédéterminées. La simulation permet d'obtenir au moins un pic 801, 802 de défauts crées dans la première couche 100 par les lacunes et/ou l'ionisation des particules générées par les collisions entre les neutrons incidents et les atomes de la deuxième espèce dopante.

On identifie ensuite la profondeur du pic de défauts 801 le plus proche de l'interface entre les première et deuxième couches 100, 400. Selon un exemple non limitatif de l'invention, un premier pic 801 correspondant à la fin de parcours des particules de lithium est déterminé à une profondeur comprise entre 1.5 et 2x10⁴ Angstrom (1Å = 10⁻¹⁰m) à partir de l'interface entre la deuxième couche 400 et la zone de charge d'espace 500. Un deuxième pic 802 correspondant à la fin de parcours des particules d'Hélium est déterminé à une profondeur comprise entre 3.4 et 3.6x10⁴Å à partir de l'interface entre la deuxième couche 400 et la zone de charge d'espace 500.

Avantageusement, la zone de charge d'espace 500 est située à l'emplacement où l'ionisation est maximale (sans polarisation extérieure), c'est-à-dire dans une zone située à proximité de l'interface séparant la première couche 100 de la deuxième couche 400 ; ladite deuxième couche 400 représentant une partie dopée de la première couche 100.

D'autre part, la zone de charge d'espace 500 est de manière particulièrement avantageuse située en dehors des premier et deuxième pics de défauts (lacunes) 801, 802 ; lesquelles lacunes étant dues aux collisions entre les atomes de Lithium (⁷Li) (et d'Hélium (⁴He)) et les atomes formant la première couche 100 réalisée en carbure de silicium.

La position et la profondeur de la zone de charge d'espace 500, là où le taux d'ionisation est maximal et où il n'y a pas de pic de défauts permettent d'obtenir un signal important et fiable sans polarisation externe. Par ailleurs, cela permet de discriminer les neutrons des photons gamma, l'épaisseur de la ZCE étant suffisamment faible pour que la détection des photons gamma soit distincte de celle des neutrons. Les photons gamma auront une faible probabilité d'interaction dans la ZCE étant donné sa faible épaisseur.

Pour évaluer la trajectoire des particules (⁷Li) et d'Hélium (⁴He) générées suite aux collisions et ainsi simuler le positionnement de pic de défauts 801, 802 en résultant en fonction de la profondeur dans la première couche 100, des simulations préalables sont requises. Dans cet exemple de réalisation, les dispositifs ont été testés au sein d'un réacteur nucléaire expérimental à une température avoisinant les 50°C.

Les simulations de la trajectoire des particules et des pics de défauts sont par exemple réalisées par SRIM acronyme en anglais pour « Stopping and Range of Ions in Matter », dans le document F.Issa et al, « Radiation Silicon Carbide Detectors based on Ion Implantation of Boron », IEEE Transations on Nuclear Science, vol. 61, n°4, August 2014.

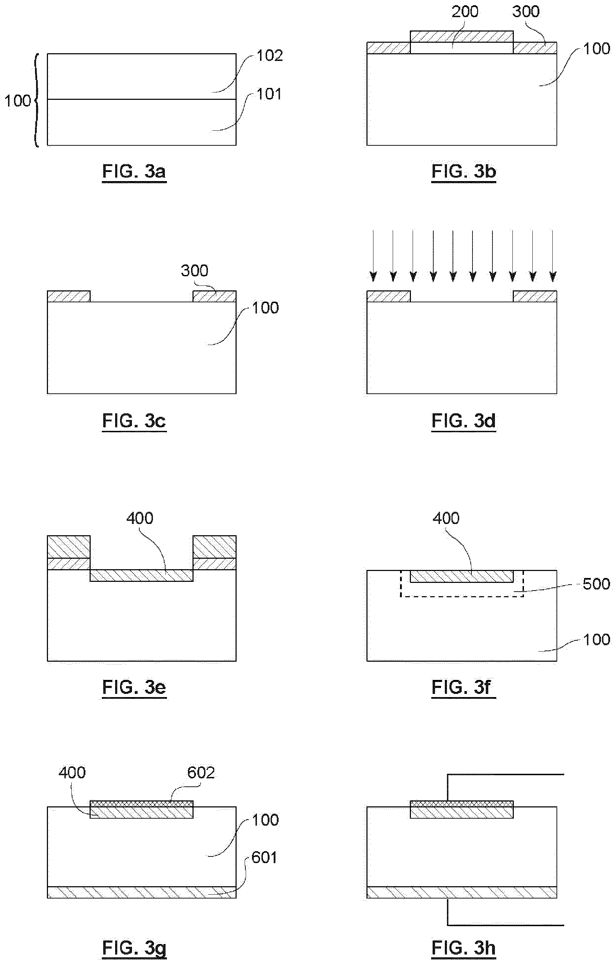

Les figures 3A à 3H illustrent les étapes d'un exemple de procédé en vue de réaliser et fabriquer le dispositif de détection de neutrons selon l'invention à partir d'un empilement modélisé de couches.

La **figure 3A** illustre une vue schématique du substrat 100. Selon un mode de réalisation particulièrement avantageux, le substrat 100 comprend un empilement de couches dont une couche inférieure 101 et une couche supérieure 102. La couche inférieure 101 forme un substrat de préférence de carbure de silicium (SiC). La couche inférieure 101 est avantageusement fortement dopée (niveau de dopage de l'ordre de quelques 10¹⁸ cm³). La couche inférieure 101 avantageusement de type n+, est réalisée par dopage à l'azote. L'épaisseur de cette couche inférieure 101 approxime par exemple les 350 micromètres.

La couche supérieure 102 comprend préférentiellement du carbure de silicium de type n, à faible niveau de dopage (concentration comprise entre 1x10¹⁴ et 1x10¹⁶ at/cm³). La couche supérieure 102 est avantageusement formée par épitaxie sur la couche inférieure 101. Selon un mode de réalisation avantageux, la couche supérieure 102 est réalisée par croissance, de préférence de type dépôt chimique en phase vapeur (ou acronyme CVD en anglais pour « chemical vapor déposition ») ou par épitaxie en phase liquide (ou acronyme LPE en anglais pour « liquid phase epitaxy ») sur la couche inférieure 101. La couche supérieure 102 est de préférence dopée à l'azote. L'épaisseur de la couche supérieure 102 est par exemple comprise entre 5 et 20 micromètres.

La **figure 3B** illustre la formation de motifs sur le substrat 100 (et plus précisément sur la couche supérieure 102 du substrat 100) à partir d'une couche de masquage 200. La réalisation d'un ou plusieurs motifs dans une couche mince est couramment effectuée à l'aide d'un procédé de photolithographie au cours duquel on forme une couche de masquage 200 ayant un motif que l'on souhaite reporter dans la couche mince. Le report est ensuite réalisé par gravure de la couche mince à travers la couche de masquage 200. Selon un mode de réalisation préféré, une couche additionnelle 300 est déposée sur le substrat 100 de sorte à recouvrir à la fois la couche supérieure 102 du substrat 100 et la couche de masquage 200. Avantageusement, la couche de masquage 200 comprend une résine photosensible présentant des flancs négatifs après développement. Cette géométrie particulière permet d'obtenir une discontinuité de la couche additionnelle 300 déposée. La couche additionnelle 300 présente ainsi des parties basses correspondant aux parties où la couche additionnelle 300 est directement déposée en contact avec la deuxième couche 102 et des parties hautes correspondant aux parties où la couche additionnelle 300 est déposée sur la couche de masquage 200. La couche additionnelle 300 est formée de préférence à base d'oxyde. La couche 300 peut comprendre par exemple de l'oxyde de silicium (SiO₂) ou de l'oxynitrure de silicium (SiON).

La **figure 3C** illustre l'étape de retrait partiel de la couche additionnelle 300, formant des motifs sur la couche supérieure 101 du substrat 100. L'étape de retrait partiel comprend de préférence une gravure humide. Avantageusement, cette gravure est réalisée par une technique dite « Lift-off » (que l'on peut qualifier de « soulèvement » en français), consistant à effectuer le retrait de la couche de masquage 200 par dissolution de la résine, de sorte à ne conserver la couche additionnelle 300 que sur les parties basses, parties qui ne reposent pas sur la couche de masquage 200.

La **figure 3D** illustre l'étape d'implantation ionique de la deuxième espèce dopante dans le substrat 100. Les paramètres de l'implantation, en particulier l'énergie et la dose, vont déterminer la profondeur de l'implantation de la deuxième espèce dopante dans le substrat. La technique d'implantation jour aussi. Avantageusement, les parties basses restantes après le retrait partiel de la couche additionnelle 300 servent de protection lors de l'implantation. La couche additionnelle 300 fait ainsi office de masque lors de l'implantation L'étape d'implantation comprend un bombardement de la couche supérieure 102 du substrat 100 avec des ions, afin d'implanter ces ions en dose suffisante pour former dans la couche supérieure 102 du substrat 100 une deuxième couche 400. Cette deuxième couche 400 du substrat 100 est avantageusement dopée à l'aide d'une deuxième espèce dopante choisie parmi les matériaux convertisseurs de neutrons, de manière à ce que la couche de conversion de neutrons soit formée par la deuxième couche 400. L'espèce implantée est choisie de manière à permettre une conversion des neutrons. La deuxième couche 400 forme ainsi une couche de conversion de neutrons, contenue dans le substrat 100. Avantageusement, cette couche de conversion de neutrons ou deuxième couche 400 comprend, suite à l'implantation, une forte dose de matériau dopant. Avantageusement la concentration de deuxième espèce dopante dans le substrat 100 est supérieure à 1x10¹⁹ at/cm³. Typiquement, elle est comprise entre 1x10¹⁹ at/cm³ et à 1x10²¹ at/cm³. Le matériau dopant est conformé de sorte à créer des paires électrons/trous. Le matériau dopant est avantageusement choisi pour réagir fortement avec les neutrons.
Les ions utilisés pour cette implantation sont de préférence choisis parmi le Bore, de type bore isotope 10 (¹⁰B) pour former une couche de type p. Selon d'autres modes de réalisation, la deuxième espèce dopante pourrait être choisie parmi l'Aluminium, le Béryllium.
Selon un mode de réalisation, l'implantation est effectuée avec une énergie comprise entre 20 et 180 keV pour une dose de Bore comprise entre 10¹⁵ et 10¹⁷ cm⁻². Selon ce mode de réalisation, l'implantation est effectuée à l'aide d'un implanteur conventionnel. Selon un autre mode de réalisation dit « plasma », l'implantation est effectuée avec une tension comprise entre 5 et 15 kV pour une dose de Bore comprise entre 10¹⁵ et 10¹⁷ cm⁻². Selon ce mode de réalisation, l'implantation est réalisée dans un réacteur plasma. L'implantation n'est effectuée, dans la couche supérieure 102 de la première couche 100, qu'au niveau des motifs ; motifs qui forment des ouvertures. Avantageusement, le procédé d'implantation par plasma minimise le taux de défauts générés.

Préalablement à l'étape d'implantation, on réalise une étape de simulation de sorte à identifier le positionnement et la profondeur de la zone de charge d'espace 500 et les premier et deuxième pics de défauts 801, 802. Les pics de défauts correspondent aux zones où la concentration de lacunes dépasse 0.005 lacunes/(Å-ion). La zone de charge d'espace 500 doit alors être positionnée à l'interface entre la deuxième couche 400 (soit la couche de conversion d'électrons) et le premier pic de défauts 801.
Les paramètres pour déterminer l'étendue de la zone de charge d'espace 500 comprennent les paramètres de dopage et d'épaisseur de la couche supérieure 102 de la première couche 100 du substrat ainsi que les paramètres de dopage du matériau dopant de la deuxième espèce dopante formant la deuxième couche ou couche de conversion de neutrons 400. Les paramètres pour déterminer le positionnement des pics de défauts 801, 802 dans la première couche 100 du substrat sont les paramètres de dopage de la deuxième espèce dopante. Le tableau suivant donne des exemples de paramètres de dopage de la deuxième espèce dopante de la deuxième couche 400 utilisés lors de l'étape de simulation. Il est entendu que ces doses pourront avantageusement varier en fonction des applications du détecteur.

| Elément implanté | Energie des ions (keV) | Dopage (10¹⁴ cm⁻²) |
|---|---|---|
| ¹⁰B | 20 | 3.5 |
| | 50 | 5 |
| | 90 | 6.3 |
| | 140 | 7.4 |
| | 180 | 8.5 |

La **figure 3E** illustre l'étape de formation de la deuxième couche 400 du substrat par implantation de la deuxième espèce dopante dans la couche supérieure 102 de la première couche 100 du substrat. Suite à l'étape d'implantation, il se forme une zone de charge d'espace 500 s'étendant au travers de la première couche 100 du substrat depuis l'interface entre la première couche 100 et la deuxième couche 400 jusqu'à une profondeur contrôlée inférieure à la profondeur donnée, de manière à ne pas inclure dans ladite zone de charge d'espace 500 lesdits pics de défauts 801, 802.

L'énergie des ions implantés définit la position de la ZCE 500, typiquement la profondeur à laquelle l'interface p/n délimitant la limite supérieure de la ZCE 500 est située. La dose implantée définit quant à elle, au moins en partie, l'épaisseur de la ZCE 500, c'est-à-dire la profondeur sur laquelle s'étend la ZCE 500 à partir de l'interface p/n. Le dopage du substrat 100 influence également l'épaisseur de la ZCE 500.

Ainsi, l'interface p/n de la zone de charge d'espace 500 et la zone de conversion de neutrons sont définies par une même espèce : la deuxième espèce dopante. Par conséquent, la zone de charge d'espace 500 est adjacente à la couche de conversion de neutrons. Il n'y a pas de couche intermédiaire entre ZCE 500 et CCN. Cela apparaît clairement sur les figures 2 et 3F par exemple. Comme indiqué précédemment, le maximum du taux d'ionisation en sortie de la CCN est donc situé dans la ZCE puisque cette dernière est directement au contact de la CCN. Cela permet d'améliorer considérablement le ratio signal sur bruit.

L'implantation de la deuxième espèce dopante est effectuée de manière à ce que la CCN s'étende depuis l'électrode au contact de la ZCE 500, dans l'exemple illustré l'électrode 602 qui sera formée ultérieurement. Ainsi, la CCN n'est pas enterrée dans la ZCE ou dans une autre couche, en étant positionnée à distance de l'électrode. Ainsi le substrat 100 initial est enrichi en deuxième espèce dopante de manière continue depuis sa face supérieure et jusqu'à l'interface formant la jonction p/n. Cette continuité de la présence de la deuxième espèce dopante n'implique cependant pas que la concentration de deuxième espèce dopante soit constante sur cette épaisseur.

La **figure 3F** illustre l'étape de recuit d'activation. Avantageusement, le recuit d'activation est réalisé de préférence sous Argon, à une température de préférence comprise entre 900 et 1700°C, pendant une durée de préférence comprise entre 30 et 120 minutes. Le recuit post-implantation est réalisé après le retrait de la couche additionnelle 300. Avantageusement, ce recuit permet d'activer électriquement les atomes de Bore implantés pour la création de la couche p+. Par ailleurs, ce recuit permet de supprimer une partie au moins des défauts crées par l'implantation de bore. La vitesse de chauffe élevée (de préférence de l'ordre de 20°C/s), couplée avec un mode de chauffe résistif qui impose une bonne homogénéité latérale en température, permet de conserver une faible rugosité de surface du carbure de silicium, et ainsi de limiter la perte de Bore par exo-diffusion. On entend par exo-diffusion, l'évaporation - soit, la perte - du dopant par la surface se produisant généralement lors du recuit d'activation.
Selon un exemple de réalisation, le recuit est effectué en deux étapes successives correspondant à des paliers différents de température. Le recuit est d'abord effectué sous une température avoisinant les 900°c pendant 120 minutes avec une vitesse de chauffe de 20°C par seconde, puis le recuit atteint les 1650°C pendant 30 minutes suivi d'une vitesse de refroidissement de 20°C par minute.

La **figure 3G** illustre l'étape de métallisation d'une première face et d'une deuxième face du substrat 100. L'étape de métallisation est réalisée de sorte à former une première couche métallique 602 sur la première face du substrat 100. Préférentiellement, la première face du substrat 100 est la face à partir de laquelle a été formée la deuxième couche 400. Le flux de neutrons pénètre dans le substrat d'abord par cette face. Avantageusement, la première couche métallique 602 forme une électrode, communément appelée cathode (ou anode). La première couche métallique 602 est effectuée de sorte à au moins couvrir la couche de conversion de neutrons 400 (ou deuxième couche 400). Préférentiellement, la première couche métallique 602 comprend un empilement de couches. Selon un exemple de réalisation, la première couche métallique 602 comprend un empilement de matériaux de type Nickel/Titanium/Aluminium. L'épaisseur de la première couche métallique 602 est de préférence comprise entre 100 et 500 nanomètres.
L'étape de métallisation est réalisée de sorte à former une deuxième couche métallique 601 sur la deuxième face du substrat 100 ; ladite deuxième face étant opposée à la première face. Avantageusement, la deuxième couche métallique 601 forme une électrode, communément appelée anode (ou cathode). La deuxième couche métallique 601 est effectuée de sorte à couvrir au moins en partie la deuxième face du substrat 100, ladite deuxième face étant opposée à la première face du substrat 100. Préférentiellement, la deuxième couche métallique 601 comprend un empilement de couches. Selon un exemple de réalisation, la deuxième couche métallique 601 comprend un empilement de matériaux de type Titanium/Nickel. L'épaisseur de la deuxième couche métallique 601 est de préférence comprise entre 100 et 500 nanomètres.

La **figure 3H** illustre la prise de contact aux bornes des première et deuxième électrodes 601, 602, c'est-à-dire aux bornes respectivement de l'anode et de la cathode 601, 602.

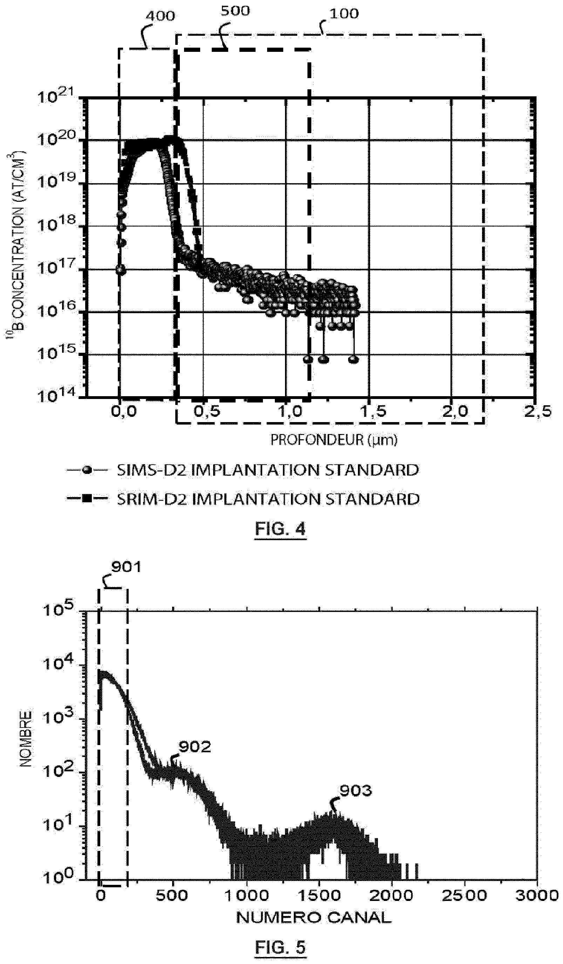

La **figure 4** représente une superposition de profils de Bore de type bore isotope 10 (¹⁰B) dans la couche supérieure 102 épitaxiée formée de carbure de silicium. Le profil simulé (symbole carré plein) après implantation du matériau dopant (dans cet exemple du Bore) et le profil expérimental de type spectrométrie de masse à ionisation secondaire SIMS (acronyme en anglais pour « secondary ion mass spectrometry ») après recuit (symbole rond plein), au travers de la deuxième couche 400 et la première couche 100, sont comparés. Les caractéristiques spécifiques du four utilisé lors du recuit ainsi que le procédé technologique de recuit associé aboutissent avantageusement à une très faible perte de Bore durant le recuit tout en limitant fortement une diffusion du Bore en volume. Ces derniers effets sont particulièrement difficiles à obtenir. Il est en effet courant d'observer après implantation de Bore dans du carbure de silicium une importante diffusion (thermique et/ou assistée par défaut) pendant le recuit, autrement dit un élargissement de profil en volume associé à une diminution importante du plateau de concentration.

Dans la présente invention, la zone de charge d'espace 500 conserve avantageusement la même position avant et après recuit, ce qui permet d'obtenir une très bonne adéquation entre les résultats expérimentaux et les travaux de simulation.

La **figure 5** illustre la variation du signal en fonction de la tension de polarisation. Trois pics 901, 902, 903 sont observés. Le premier pic 901 (numéros de canal inférieurs à 250) est lié à la détection de rayons gamma, ce qui est confirmé par un élargissement du pic 901 en fonction de la polarisation (élargissement de la zone de charge d'espace 500). Le troisième pic 903 (canal≈1500) est directement lié à la détection de neutrons thermiques incidents. L'intensité de ce pic 903 est proportionnelle au flux de neutrons thermiques. Il n'est pas détecté de variation de l'intensité de ce pic 903 en fonction de la polarisation. Avantageusement, cela implique de pouvoir travailler sans polarisation extérieure, autrement dit d'avoir un système énergiquement autonome. Dans cet exemple, les expériences ont été menées à une température avoisinant les 170°C. Aucune variation notable du signal n'a été observée.

Au vu de ce qui précède il apparaît que la présente invention propose un procédé de réalisation simplifié par la formation de la couche de conversion d'électrons et la formation de la jonction p-n réalisées en une seule étape. Le procédé selon la présente invention permet de s'affranchir du travail consistant à optimiser la distance entre la couche de conversion d'électrons et la zone de charge d'espace, et cela notamment grâce à l'identité de fait entre la couche de conversion d'électrons et la couche implantée p+. D'autre part, les limites de l'utilisation du détecteur en milieu sévère ne sont liées qu'aux propriétés physiques du carbure de silicium (et aux connexions), puisque le détecteur est entièrement basé sur ce matériau.

De manière particulièrement avantageuse, la réalisation de la couche de conversion de neutrons par implantation de Bore de préférence de type isotope 10 (¹⁰B) dans un substrat comprenant de préférence du carbure de silicium permet de limiter les contraintes (thermiques, mécaniques, etc.). D'autre part, le carbure de silicium permet avantageusement de travailler en environnement extrême, tout en conservant un bon rapport signal sur bruit.

D'autre part, les simulations (par exemple de type SRIM) permettent d'optimiser l'épaisseur et le dopage des couches p⁺ et n, définissant ainsi la position et l'épaisseur de la zone de charge d'espace pour qu'elle soit située en dehors des pics de défauts provoqués par la génération de particules de Lithium et d'Hélium, augmentant ainsi la durée de vie du détecteur et l'obtention d'un signal sans polarisation extérieure (très bonne discrimination entre neutrons et gamma). De plus, la maîtrise des paramètres technologiques (implantation/recuit) permet d'aboutir à la maîtrise des paramètres de la couche p⁺. Avantageusement, l'introduction d'une grande quantité de bore isotope 10 (¹⁰B) par implantation ionique, grande quantité correspondant par exemple à la limite de solubilité dans le carbure de silicium, même si elle peut aboutir à une diode de faible qualité (courant « de fuite » élevé), donne lieu à un détecteur de neutrons (détection de faibles flux) fiable, de très bonne qualité tout en restant peu coûteux.

La détection de neutrons présente plusieurs champs d'application. Chaque application nécessite différents systèmes de détection. La détection de neutrons est, par exemple, utilisée pour les réacteurs nucléaires expérimentaux et de puissance, la géo-prospection géophysique minière et pétrolière (par exemple, recherche de nappes de pétrole), le contrôle nucléaire de procédé dans les usines de retraitement du combustible, la caractérisation de colis de déchets radioactifs, le suivi et le contrôle des opérations de démantèlement d'installations nucléaires, la physique médicale ou encore l'environnement.

Au vu de la description qui précède, il apparait que le détecteur selon l'invention présente de nombreux avantages.

La localisation de la ZCE, adjacente à la CCN, ainsi qu'en dehors du pic de défauts, permet d'améliorer considérablement la durée de vie du détecteur, plus fiable au cours du temps et le ratio signal sur bruit. Ainsi il permet de se passer d'une polarisation.

Par ailleurs, le procédé selon l'invention de fabrication de détecteurs le rend très adaptable et modulable en fonction de l'application souhaitée. En effet l'absence de couche intermédiaire entre ZCE et CCN permet de faire facilement varier l'épaisseur de la CCN et celle de la ZCE, par exemple pour s'adapter aux signaux de l'application mesurée, tout en étant toujours assuré que le maximum d'ionisation est toujours dans le ZCE. Avec les détecteurs de l'art antérieur il est difficile d'ajuster la distance entre CCN et ZCE.

Par ailleurs, le détecteur selon l'invention de par sa conception, se montre particulièrement robuste dans un environnement dit « sévère » c'est-à-dire présentant de fortes températures, des pressions élevées et des niveaux d'irradiations importants. A titre d'exemple, un environnement sévère présente au moins l'une des conditions suivantes: une température minimale de 150°C, une pression minimale de 10 bars et/ou une irradiation minimale de 10⁹ n.cm⁻².s⁻¹ sous 10 Gy.s-1.

A contrario, la principale limite d'utilisation des détecteurs existants de neutrons réside d'une part dans les contraintes d'utilisation (température, pression, irradiations, etc.), les dispositifs ne résistant pas à de telles contraintes, et présentant ainsi des dysfonctionnements dont par exemple une durée de vie limitée et d'autre part dans le choix à faire concernant l'augmentation des performances du détecteur au détriment de sa durée de vie.

De plus, ces solutions de l'art antérieur prévoient nécessairement la mise en place d'une polarisation inverse qui est nécessaire pour obtenir un signal exploitable. Cette polarisation complexifie le détecteur et réduit la discrimination entre les neutrons et les particules gamma.

Par ailleurs, en prévoyant l'implantation d'une même espèce pour former à la fois la CCN et définir la jonction p/n pour la ZCE, le détecteur selon l'invention est plus rapide, plus simple et moins couteux à fabriquer.

La présente invention n'est pas limitée aux modes de réalisation précédemment décrits mais s'étend à tout mode de réalisation conforme à la portée des revendications annexées. En outre, bien que dans l'exemple précédent l'espèce implantée qui convertit les neutrons soit le Bore, l'invention n'est pas limitée à cette espèce.

## Revendications

1. Procédé de réalisation d'un dispositif de détection d'un flux de neutrons présentant des caractéristiques comprises dans des gammes prédéterminées, **caractérisé en ce qu'**il comprend au moins:
- une phase de détermination de paramètres du détecteur, cette phase comprenant les étapes suivantes :
- simuler la pénétration d'un flux de neutrons incidents présentant des caractéristiques comprises dans lesdites gammes prédéterminées à travers un empilement modélisé comprenant successivement et dans l'ordre au moins:
- une première électrode (601) ;
- un substrat comprenant :
o une première couche (100) dopée comprenant au moins une première espèce dopante de manière à ce que la première couche (100) soit une couche dopée n ou une couche dopée p, la première couche (100) étant formée par le substrat ;
o une deuxième couche (400) dopée comprenant au moins une deuxième espèce dopante de manière à ce que la deuxième couche (400) soit l'autre parmi une couche dopée n ou une couche dopée p de sorte à former, à une interface entre les première (100) et deuxième (400) couches, une jonction p-n et de manière à former dans la première couche (100) et à partir de l'interface entre les première (100) et deuxième (400) couches, une zone de charge d'espace (500) ; la deuxième couche (400) étant formée par implantation de ladite deuxième espèce dopante dans le substrat ; ladite deuxième espèce dopante étant prise parmi les matériaux convertisseurs de neutrons de manière à ce que la deuxième couche (400) forme une couche de conversion de neutrons ;
- une deuxième électrode (602) ;
- simuler au moins un pic (801, 802) de défauts crées dans la première couche (100) de l'empilement modélisé par les lacunes et/ou l'ionisation des particules générées par les collisions entre les atomes de ladite deuxième espèce dopante et les neutrons dudit flux de neutrons incidents présentant des caractéristiques comprises dans lesdites gammes prédéterminées;
- identifier la profondeur du pic (801) de défauts le plus proche de l'interface entre les première (100) et deuxième (400) couches de l'empilement modélisé ;
- déterminer des paramètres des première (100) et deuxième couches (400) que devrait présenter l'empilement modélisé, notamment la profondeur de ladite implantation de ladite deuxième espèce dopante dans le substrat pour former la deuxième couche (400) et les teneurs en première et deuxième espèces dopantes respectivement des première (100) et deuxième couches (400), de manière à ce que la zone de charge d'espace s'étende depuis ladite interface entre les première (100) et deuxième (400) couches et dans la première couche (100) sur une profondeur inférieure à ladite profondeur identifiée dudit pic (801) de défauts de manière à ce que la zone de charge d'espace (500) ne comprenne pas de pic (801, 802) de défauts ;
- une étape de fabrication du dispositif de détection dans laquelle on réalise la première couche puis on réalise la deuxième couche (400) par implantation de ladite deuxième espèce dopante dans une partie de la première couche (100), ladite implantation, en particulier la profondeur d'implantation et la teneur en ladite deuxième espèce dopante, étant réalisée en fonction desdits paramètres déterminés de manière à ce que dans le dispositif fabriqué la zone de charge d'espace s'étende depuis ladite interface entre les première (100) et deuxième (400) couches et dans la première couche (100) sur une profondeur inférieure à ladite profondeur identifiée dudit pic (801) de défauts.

2. Procédé selon la revendication précédente dans lequel lesdites caractéristiques prédéterminées du flux de neutrons comprennent au moins l'un parmi: une énergie donnée et/ou une fluence et/ou une intensité.

3. Procédé selon l'une quelconque des revendications précédentes dans lequel au cours de l'étape de fabrication, on règle la profondeur de la zone de charge d'espace (500) en fonction des paramètres suivants : la teneur en première espèce dopante de la première couche (100) ; la dose de l'implantation de ladite deuxième espèce dopante, la profondeur de l'implantation de ladite deuxième espèce dopante.

4. Procédé selon l'une quelconque des revendications précédentes dans lequel au cours de l'étape de fabrication on détermine la position de la zone de charge d'espace (500) en fonction des paramètres suivants : l'épaisseur de la deuxième couche (400) et/ou l'énergie de l'implantation de ladite deuxième espèce dopante.

5. Procédé selon l'une quelconque des revendications précédentes dans lequel la première couche (100) du substrat est exempte de la deuxième espèce dopante.

6. Procédé selon l'une quelconque des revendications précédentes dans lequel ladite deuxième espèce dopante comprend du bore isotope 10 (¹⁰B).

7. Procédé selon l'une quelconque des revendications précédentes dans lequel la première couche (100) du substrat comprend au moins une couche inférieure (101) dopée n+ et une couche supérieure (102) dopée n ; ladite couche supérieure (102) comprenant une concentration en première espèce dopante comprise entre 10¹⁴ et 10¹⁶ at/cm³.

8. Procédé selon l'une quelconque des revendications précédentes dans lequel la première électrode (601) est au contact de la première couche (100), la première couche (100) est au contact de la deuxième couche (400) et la deuxième électrode (602) est au contact de la deuxième couche (400).

9. Procédé selon l'une quelconque des revendications précédentes dans lequel le pic de défauts (801, 802) est une zone dans laquelle la concentration en défauts est supérieure ou égale à 0.005 lacune/(Â-ion).

10. Procédé selon l'une quelconque des revendications précédentes dans lequel on règle la profondeur de la zone de charge d'espace, notamment en ajustant les teneurs en première et deuxième espèces dopantes des première et deuxième couches et notamment en ajustant l'implantation de ladite deuxième espèce dopante, de manière à ce que la zone de charge d'espace (500) s'étend dans la première couche, à partir de ladite interface, sur une profondeur suffisante pour comprendre la zone où le taux d'ionisation des particules générées par lesdites collisions entre les atomes de ladite deuxième espèce dopante et les neutrons dudit flux de neutrons incidents présentant des caractéristiques comprises dans lesdites gammes prédéterminées, est maximum.

11. Procédé selon l'une quelconque des revendications précédentes dans lequel l'implantation de ladite deuxième espèce dopante est réalisée :
- soit au moyen de Bore isotope 10, avec une énergie comprise entre 20 et 180 keV et une dose comprise entre 10¹⁵ et 10¹⁷ cm⁻²,
- soit par implantation plasma de Bore isotope 10, avec une tension comprise entre 5 et 15 kV et une dose comprise entre 10¹⁵ et 10¹⁷ cm⁻².

12. Procédé selon l'une quelconque des revendications précédentes dans lequel l'étape de détermination des paramètres du détecteur est au moins en partie assistée ou mise en œuvre par ordinateur.

13. Procédé selon l'une quelconque des revendications 1 à 11 dans lequel l'étape d'identification du pic de défauts comprend des analyses de microscopie électronique effectuées sur au moins un empilement modélisé préalablement fabriqué et soumis à un flux de neutrons présentant des caractéristiques comprises dans lesdites gammes prédéterminées.

14. Détecteur d'un flux de neutrons dont les paramètres du flux de neutrons présentant des caractéristiques comprises dans des gammes prédéterminées, le détecteur comprenant au moins un empilement de couches comprenant successivement et dans l'ordre :
- une première électrode (601) ;
- un substrat comprenant :
- une première couche (100) dopée comprenant au moins une première espèce dopante de manière à ce que la première couche (100) soit une couche dopée n ou une couche dopée p, la première couche (100) étant formée par le substrat ;
- une deuxième couche (400) dopée comprenant au moins une deuxième espèce dopante de manière à ce que la deuxième couche (400) soit l'autre parmi une couche dopée n ou une couche dopée p de sorte à former, à une interface entre les première (100) et deuxième (400) couches, une jonction p-n et de manière à former dans la première couche (100) et à partir de l'interface entre les première (100) et deuxième (400) couches, une zone de charge d'espace (500) ; la deuxième couche (400) étant formée par implantation de ladite deuxième espèce dopante dans le substrat ;
- une deuxième électrode (602) ;
**caractérisé en ce que** :
- ladite deuxième espèce dopante étant prise parmi les matériaux convertisseurs de neutrons de manière à ce que la deuxième couche (400) forme une couche de conversion de neutrons ;
- les paramètres des première (100) et deuxième (400) couches, en particulier la profondeur d'implantation de ladite deuxième espèce dopante dans le substrat pour former la deuxième couche (400) et les teneurs en première et deuxième espèces dopantes respectivement des première (100) et deuxième (400) couches, sont choisis de telle manière que la zone de charge d'espace (500) s'étend depuis ladite interface entre les première (100) et deuxième (400) couches et dans la première couche (100) sur une profondeur inférieure à une profondeur où se situerait un pic (801, 802) de défauts qui serait créé dans la première couche (100) par des lacunes et/ou une ionisation de particules générées par les collisions entre des atomes de ladite deuxième espèce dopante et des neutrons si le détecteur était exposé à un flux de neutrons incidents présentant des caractéristiques comprises dans lesdites gammes prédéterminées.

15. Utilisation du détecteur selon la revendication précédente dans laquelle on expose le détecteur à un flux de neutrons dont les caractéristiques sont comprises dans lesdites gammes prédéterminées, l'utilisation étant:
- pour l'une quelconque des applications suivantes : caractérisation de colis de déchets radioactifs, le suivi et le contrôle des opérations de démantèlement d'installations nucléaires, le contrôle nucléaire dans des usines de retraitement de combustible nucléaire, le pilotage de réacteurs nucléaires expérimentaux et de puissance, le contrôle de l'environnement,
ou
- pour la géo prospection minière ou pétrolière, ou
- pour la physique médicale, ou
- pour le domaine de la sécurité intérieure.

## Patentansprüche

1. Verfahren zur Herstellung einer Vorrichtung zur Detektion eines Neutronenflusses mit Merkmalen in vorbestimmten Bereichen, **dadurch gekennzeichnet, dass** es mindestens umfasst:
- eine Phase des Bestimmens von Parametern des Detektors, wobei diese Phase die folgenden Schritte umfasst:
- Simulieren des Dringens eines Flusses einfallender Neutronen mit Merkmalen in den vorbestimmten Bereichen durch einen modellierten Stapel, der nacheinander und in dieser Reihenfolge mindestens umfasst:
- eine erste Elektrode (601);
- ein Substrat, welches umfasst:
o eine erste dotierte Schicht (100), die mindestens eine erste Dotierungsspezies umfasst, sodass es sich bei der ersten Schicht (100) um eine n-dotierte Schicht oder eine p-dotierte Schicht handelt, wobei die erste Schicht (100) vom Substrat gebildet wird;
o eine zweite dotierte Schicht (400), die mindestens eine zweite Dotierungsspezies umfasst, sodass es sich bei der zweiten Schicht (400) um das andere aus einer n-dotierten Schicht oder einer p-dotierten Schicht handelt, um an einer Grenzfläche zwischen der ersten (100) und zweiten Schicht (400) einen p-n-Übergang zu bilden und um in der ersten Schicht (100) und von der Grenzfläche zwischen der ersten (100) und zweiten (400) Schicht ausgehend eine Raumladungszone (500) zu bilden; wobei die zweite Schicht (400) durch Implantation der zweiten Dotierungsspezies in das Substrat gebildet wird; wobei die zweite Dotierungsspezies aus den Neutronenkonverter-Materialien ausgewählt ist, sodass die zweite Schicht (400) eine Neutronenkonversionsschicht bildet;
- eine zweite Elektrode (602);
- Simulieren mindestens eines Peaks (801, 802) von Defekten, die durch die Lücken und/oder die Ionisation der durch die Kollisionen zwischen den Atomen der zweiten Dotierungsspezies und den Neutronen des Flusses einfallender Neutronen mit Merkmalen in den vorbestimmten Bereichen entstehenden Partikel in der ersten Schicht (100) des modellierten Stapels erzeugt werden;
- Identifizieren der Tiefe des Defekt-Peaks (801), der am nähesten an der Grenzfläche zwischen der ersten (100) und zweiten (400) Schicht des modellierten Stapels liegt;
- Bestimmen von Parametern der ersten (100) und zweiten Schicht (400), die der modellierte Stapel aufweisen sollte, vor allem der Tiefe der Implantation der zweiten Dotierungsspezies in das Substrat, um die zweite Schicht (400) zu bilden, und des Gehalts der ersten (100) und zweiten Schicht (400) an erster bzw. zweiter Dotierungsspezies so, dass sich die Raumladungszone ab der Grenzfläche zwischen der ersten (100) und zweiten (400) Schicht und in der ersten Schicht (100) auf einer Tiefe erstreckt, die kleiner ist als die identifizierte Tiefe des Defekt-Peaks (801), sodass die Raumladungszone (500) keinen Defekt-Peak (801, 802) umfasst;
- einen Schritt des Anfertigens der Detektionsvorrichtung, bei dem die erste Schicht hergestellt wird, und anschließend die zweite Schicht (400) durch Implantation der zweiten Dotierungsspezies in einen Teil der ersten Schicht (100) hergestellt wird, wobei die Implantation, insbesondere die Implantationstiefe und der Gehalt an zweiter Dotierungsspezies, in Abhängigkeit von den bestimmten Parametern ausgeführt wird, sodass sich die Raumladungszone in der angefertigten Vorrichtung ab der Grenzfläche zwischen der ersten (100) und zweiten (400) Schicht und in der ersten Schicht (100) auf einer Tiefe erstreckt, die kleiner ist als die identifizierte Tiefe des Defekt-Peaks (801).

2. Verfahren nach dem vorstehenden Anspruch, wobei die vorbestimmten Merkmale des Neutronenflusses mindestens eines umfassen aus: einer gegebenen Energie und/oder einer Fluenz und/oder einer Intensität.

3. Verfahren nach einem der vorstehenden Ansprüche, wobei im Fertigungsschritt die Tiefe der Raumladungszone (500) in Abhängigkeit der folgenden Parameter geregelt wird: dem Gehalt der ersten Schicht (100) an erster Dotierungsspezies; der Dosis der Implantation der zweiten Dotierungsspezies, der Tiefe der Implantation der zweiten Dotierungsspezies.

4. Verfahren nach einem der vorstehenden Ansprüche, wobei im Fertigungsschritt die Position der Raumladungszone (500) in Abhängigkeit der folgenden Parameter bestimmt wird: der Dicke der zweiten Schicht (400) und/oder der Energie der Implantation der zweiten Dotierungsspezies.

5. Verfahren nach einem der vorstehenden Ansprüche, wobei die erste Schicht (100) des Substrats frei von der zweiten Dotierungsspezies ist.

6. Verfahren nach einem der vorstehenden Ansprüche, wobei die zweite Dotierungsspezies Bor-Isotop 10 (¹⁰B) umfasst.

7. Verfahren nach einem der vorstehenden Ansprüche, wobei die erste Schicht (100) des Substrats mindestens eine untere n+-dotierte Schicht (101) und eine obere n-dotierte Schicht (102) umfasst; wobei die obere Schicht (102) eine Konzentration an erster Dotierungsspezies zwischen 10¹⁴ und 10¹⁶ at/cm³ umfasst.

8. Verfahren nach einem der vorstehenden Ansprüche, wobei die erste Elektrode (601) mit der ersten Schicht (100) in Kontakt steht, die erste Schicht (100) mit der zweiten Schicht (400) in Kontakt steht, und die zweite Elektrode (602) mit der zweiten Schicht (400) in Kontakt steht.

9. Verfahren nach einem der vorstehenden Ansprüche, wobei es sich beim Defekt-Peak (801, 802) um eine Zone handelt, in der die Konzentration an Defekten größer oder gleich 0,005 Lücke/(Ä-lon) ist.

10. Verfahren nach einem der vorstehenden Ansprüche, wobei die Tiefe der Raumladungszone vor allem durch Anpassen des Gehalts der ersten und zweiten Schicht an erster und zweiter Dotierungsspezies, und vor allem durch Anpassen der Implantation der zweiten Dotierungsspezies so geregelt wird, dass sich die Raumladungszone (500) in der ersten Schicht von der Grenzfläche ausgehend auf einer Tiefe erstreckt, die ausreicht, um die Zone zu umfassen, in der die lonisationsrate der durch die Kollisionen zwischen den Atomen der zweiten Dotierungsspezies und den Neutronen des Flusses einfallender Neutronen mit Merkmalen in den vorbestimmten Bereichen entstehenden Partikel maximal ist.

11. Verfahren nach einem der vorstehenden Ansprüche, wobei die Implantation der zweiten Dotierungsspezies ausgeführt wird:
- entweder mittels Bor-Isotop 10 mit einer Energie zwischen 20 und 180 keV und einer Dosis zwischen 10¹⁵ und 10¹⁷ cm⁻²,
- oder durch Plasmaimplantation von Bor-Isotop 10 mit einer Spannung zwischen 5 und 15 kV und einer Dosis zwischen 10¹⁵ und 10¹⁷ cm⁻².

12. Verfahren nach einem der vorstehenden Ansprüche, wobei der Schritt des Bestimmens der Parameter des Detektors mindestens zum Teil computerunterstützt oder computerimplementiert erfolgt.

13. Verfahren nach einem der Ansprüche 1 bis 11, wobei der Schritt des Identifizierens des Defekt-Peaks elektronenmikroskopische Analysen umfasst, die an mindestens einem modellierten Stapel vorgenommen werden, der zuvor angefertigt und einem Neutronenfluss mit Merkmalen in den vorbestimmten Bereichen ausgesetzt wurde.

14. Detektor für einen Neutronenfluss, wobei die Parameter des Neutronenflusses Merkmale in vorbestimmten Bereichen aufweisen, wobei der Detektor mindestens einen Schichtenstapel umfasst, der nacheinander und in dieser Reihenfolge umfasst:
- eine erste Elektrode (601);
- ein Substrat, welches umfasst:
- eine erste dotierte Schicht (100), die mindestens eine erste Dotierungsspezies umfasst, sodass es sich bei der ersten Schicht (100) um eine n-dotierte Schicht oder eine p-dotierte Schicht handelt, wobei die erste Schicht (100) vom Substrat gebildet wird;
- eine zweite dotierte Schicht (400), die mindestens eine zweite Dotierungsspezies umfasst, sodass es sich bei der zweiten Schicht (400) um das andere aus einer n-dotierten Schicht oder einer p-dotierten Schicht handelt, um an einer Grenzfläche zwischen der ersten (100) und zweiten (400) Schicht einen p-n-Übergang zu bilden und um in der ersten Schicht (100) und von der Grenzfläche zwischen der ersten (100) und zweiten (400) Schicht ausgehend eine Raumladungszone (500) zu bilden; wobei die zweite Schicht (400) durch Implantation der zweiten Dotierungsspezies in das Substrat gebildet wird;
- eine zweite Elektrode (602);
**dadurch gekennzeichnet, dass**:
- die zweite Dotierungsspezies aus den Neutronenkonverter-Materialien ausgewählt ist, sodass die zweite Schicht (400) eine Neutronenkonversionsschicht bildet;
- die Parameter der ersten (100) und zweiten (400) Schicht, vor allem die Implantationstiefe der zweiten Dotierungsspezies in das Substrat, um die zweite Schicht (400) zu bilden, und der Gehalt der ersten (100) und zweiten (400) Schicht an erster bzw. zweiter Dotierungsspezies derart gewählt werden, dass sich die Raumladungszone (500) ab der Grenzfläche zwischen der ersten (100) und zweiten (400) Schicht und in der ersten Schicht (100) auf einer Tiefe erstreckt, die kleiner ist als eine Tiefe, in der ein Defekt-Peak (801, 802) liegen würde, der durch Lücken und/oder eine Ionisation von durch die Kollisionen zwischen Atomen der zweiten Dotierungsspezies und Neutronen entstehenden Partikeln in der ersten Schicht (100) erzeugt würde, wenn der Detektor einem Fluss einfallender Neutronen mit Merkmalen in den vorbestimmten Bereichen ausgesetzt wäre.

15. Verwendung des Detektors nach dem vorstehenden Anspruch, wobei der Detektor einem Neutronenfluss ausgesetzt wird, dessen Merkmale in den vorbestimmten Bereichen liegen, wobei die Verwendung dient:
- für eine der folgenden Anwendungen: Charakterisierung von Packstücken mit radioaktiven Abfällen, Verfolgung und Überwachung der Arbeiten zum Rückbau von atomaren Anlagen, atomare Überwachung in Werken zur Aufbereitung von atomaren Brennstoffen, Steuerung von experimentellen atomaren und Leistungsreaktoren, Umweltüberwachung,
oder
- für die Geoprospektion im Bergbau oder der Erdölförderung, oder
- für die Medizinphysik, oder
- für den Bereich der inneren Sicherheit.

## Claims

1. Method for producing a device for detecting a stream of neutrons having characteristics within predetermined ranges, **characterised in that** it comprises at least:
- a phase of determining parameters of the detector, this phase comprising the following steps:
- simulating the penetration of a stream of incident neutrons having characteristics within said predetermined ranges through a modelled stack comprising successively and in the following order at least:
- a first electrode (601);
- a substrate comprising:
o a first doped layer (100) comprising at least a first dopant species such that the first layer (100) is an n-doped layer or a p-doped layer, the first layer (100) being formed by the substrate;
o a second doped layer (400) comprising at least a second dopant species such that the second layer (400) is the other among an n-doped layer or a p-doped layer so as to form, at an interface between the first (100) and second (400) layers, a p-n junction and so as to form in the first layer (100) and from the interface between the first (100) and second (400) layers, a space charge region (500); the second layer (400) being formed by implanting said second dopant species in the substrate; said second dopant species being taken among neutron-converting materials such that the second layer (400) forms a neutron conversion layer;
- a second electrode (602);
- simulating at least one peak (801, 802) of defects created in the first layer (100) of the modelled stack by the gaps and/or the ionisation of the particles generated by the collisions between the atoms of said second dopant species and the neutrons of said stream of incident neutrons having characteristics within said predetermined ranges;
- identifying the depth of the defect peak (801) closest to the interface between the first (100) and second (400) layers of the modelled stack;
- determining parameters of the first (100) and second layers (400) that the modelled stack should have, particularly the depth of said implantation of said second dopant species in the substrate to form the second layer (400) and the first and second dopant species contents respectively of the first (100) and second layers (400), such that said space charge region extends from said interface between the first (100) and second (400) layers and in the first layer (100) along a depth less than said identified depth of said defect peak (801) such that the space charge region (500) comprises no defect peak (801, 802);
- a step of manufacturing the detection device wherein the first layer is produced then the second layer (400) is produced by implanting said second dopant species in a part of the first layer (100), said implantation, in particular the implantation depth and said second dopant species content, being carried out according to said determined parameters such that in the manufactured device the space charge region extends from said interface between the first (100) and second (400) layers and in the first layer (100) along a depth less than said identified depth of said defect peak (801).

2. Method according to the preceding claim wherein said predetermined characteristics of the neutron stream comprise at least one among: a given energy and/or a fluence and/or an intensity.

3. Method according to any one of the preceding claims wherein during the manufacturing step, the depth of the space charge region (500) is set according to the following parameters: the first dopant species of the first layer (100); the implantation dose of said second dopant species, the implantation depth of said second dopant species.

4. Method according to any one of the preceding claims wherein during the manufacturing step, the position of the space charge region (500) is determined according to the following parameters: the thickness of the second layer (400) and/or the implantation energy of said second dopant species.

5. Method according to any one of the preceding claims wherein the first layer (100) of the substrate is free from the second dopant species.

6. Method according to any one of the preceding claims wherein said second dopant species comprises boron-10 isotope (¹⁰B).

7. Method according to any one of the preceding claims wherein the first layer (100) of the substrate comprises at least an n+-doped bottom layer (101) and an n-doped top layer (102); said top layer (102) comprising a first dopant species concentration between 10¹⁴ and 10¹⁶ at/cm³.

8. Method according to any one of the preceding claims wherein the first electrode (601) is in contact with the first layer (100), the first layer (100) is in contact with the second layer (400) and the second electrode (602) is in contact with the second layer (400).

9. Method according to any one of the preceding claims wherein the defect peak (801, 802) is a region wherein the defect concentration is greater than or equal to 0.005 gap/(A-ion).

10. Method according to any one of the preceding claims wherein the depth of the space charge region is set, particularly by adjusting the first and second dopant species contents of the first and second layers and particularly by adjusting the implantation of said second dopant species, such that the space charge region (500) extends in the first layer, from said interface, along a sufficient depth to comprise the region where the ionisation rate of the particles generated by said collisions between the atoms of said second dopant species and the neutrons of said stream of incident neutrons having characteristics within said predetermined ranges, is maximum.

11. Method according to any one of the preceding claims wherein the implantation of said second dopant species is carried out:
- either by means of Boron-10 isotope, with an energy between 20 and 180 keV and a dose between 10¹⁵ and 10¹⁷ cm⁻²,
- or by plasma implantation of Boron-10 isotope, with a voltage between 5 and 15 kV and a dose between 10¹⁵ and 10¹⁷ cm⁻².

12. Method according to any one of the preceding claims wherein the step of determining the parameters of the detector is at least in part assisted or executed by computer.

13. Method according to any one of claims 1 to 11 wherein the step of identifying the defect peak comprises electron microscopy analyses performed on at least one modelled stack previously manufactured and subjected to a stream of neutrons having characteristics within said predetermined ranges.

14. Detector of a stream of neutrons including the parameters of the stream of neutrons having characteristics within predetermined ranges, the detector comprising at least one stack of layers comprising successively and in the following order at least:
- a first electrode (601);
- a substrate comprising:
- a first doped layer (100) comprising at least a first dopant species such that the first layer (100) is an n-doped layer or a p-doped layer, the first layer (100) being formed by the substrate;
- a second doped layer (400) comprising at least a second dopant species such that the second layer (400) is the other among an n-doped layer or a p-doped layer so as to form, at an interface between the first (100) and second (400) layers, a p-n junction and so as to form in the first layer (100) and from the interface between the first (100) and second (400) layers, a space charge region (500); the second layer (400) being formed by implanting said second dopant species in the substrate;
- a second electrode (602);
**characterised in that**:
- said second dopant species being taken among neutron-converting materials such that the second layer (400) forms a neutron conversion layer;
- the parameters of the first (100) and second (400) layers, in particular the implantation depth of said second dopant species in the substrate to form the second layer (400) and the first and second dopant species contents respectively of the first (100) and second layers (400), are chosen such that the space charge region (500) extends from said interface between the first (100) and second (400) layers and in the first layer (100) along a depth less than a depth where a defect peak (801, 802) would be located which would be created in the first layer (100) by gaps and/or an ionisation of particles generated by the collisions between atoms of said second dopant species and neutrons if the detector was exposed to a stream of incident neutrons having characteristics within said predetermined ranges.

15. Use of the detector according to the preceding claim wherein the detector is exposed to a stream of neutrons wherein the characteristics are within said predetermined ranges, the use being:
- for any of the following applications: characterising packages of radioactive waste, tracking and monitoring nuclear facility dismantling operations, nuclear monitoring in nuclear fuel reprocessing plants, experimental and power nuclear reactor control, environmental monitoring,
or
- for mining or oil geo-prospecting, or
- for medical physics, or
- for the field of internal security.
